# EUROPEAN PATENT APPLICATION

(11) **EP 2 605 297 A1**
(43) Date of publication of application: **19.06.2013**
(21) Application number: 11194036.7
(22) Date of filing: 16.12.2011
(51) Int. Cl.: H01L 33/50

(54) **Phosphor distribution for a light emitting diode**

(71) Applicant: Foxsemicon Integrated Technology, Inc., Miao-Li, Hsien 350 (TW)
(72) Inventor: Lai, Chih-Ming, Chu-Nan,Miao-Li Hsien (TW)
(74) Representative: Gray, John James

(57) **Abstract**

An LED includes an LED chip, an encapsulation encapsulating the LED chip, and a phosphor layer containing phosphor particles disposed on an outer surface of the encapsulation. A luminous intensity I of light generated by the LED chip and a radiation angle θ are in Lambertian distribution and satisfy following formula: I = I₀ xcosθ, here the radiation angle θ is not lower than 0°, and is not higher than 90°, and l₀ is a luminous intensity at a central axis of the LED chip, and the radiation angle θ is an angle between the light and the central axis. One of parameters of concentration, particle number of the phosphor particles in the phosphor layer and a thickness of the phosphor layer is also in Lambertian distribution relative to the radiation angle θ.

## Description

### BackGround

The present disclosure relates to LEDs (light-emitting diodes), and more particularly to an LED coated with a phosphor layer.

### 2. Description of Related Art

An LED (Light-Emitting Diode) as a new type of light source can generate brighter light, and have many advantages, e.g., energy saving, environment friendly and longer life-span, compared to conventional light sources. The LED generally includes an LED chip emitting blue light and a phosphor layer containing phosphor particles deposited on the LED chip. A portion of the blue light emitted by the LED chip and red and green light emitted by the phosphor layer as a result of a partial absorption of the blue light can combine to produce white light.

Usually, the white light generated by the LED is not uniform in color temperature. For example, this nonuniformity is a consequence of the variations in the thickness of the phosphor layer. The thickness of the phosphor layer causes nonuniform absorption of blue light and emission of red and green light. Light through thick regions travels longer distance and requires more time than light through thin regions. When light strikes a phosphor particle, the light is either absorbed and re-emitted at a different wavelength or scattered by the phosphor particle. Light that travels a longer distance through the phosphor layer is more likely to be absorbed and re-emitted. Conversely, light that travels a shorter distance through the phosphor layer is more likely to be scattered out of the LED without being absorbed and re-emitted. The thick regions of the phosphor layer absorb more blue light and emit more red and green light than the thin regions of the phosphor layer do. As a result, more blue light is emitted from regions of the LED corresponding to the thin regions of the phosphor layer, and more red and green light is emitted from regions of the LED corresponding to the thick regions of the phosphor layer. The light emitted from the thick regions thus tends to appear yellow or display reddish and greenish blotches, and the light emitted from the thin regions tends to appear bluish.

What is needed, therefore, is an LED which can overcome the limitations described.

### BRIEF DESCRIPTION OF THE DRAWINGS

FIG. 1 is a cross-sectional view of an LED in accordance with a first embodiment of the disclosure.

FIG. 2 is a diagram illustrating a luminous intensity distribution of an LED chip of the LED of FIG. 1.

FIG. 3 is a cross-sectional view of an LED in accordance with a second embodiment of the disclosure.

FIG. 4 is a cross-sectional view of an LED in accordance with a third embodiment of the disclosure.

### DETAILED DESCRIPTION

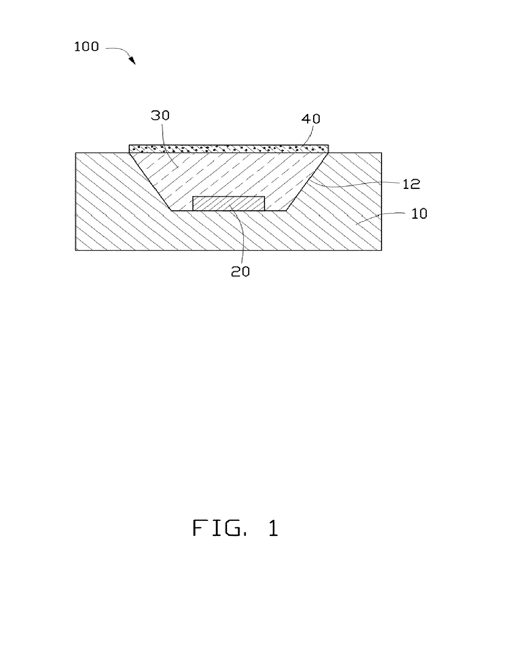

Referring to FIG. 1, an LED 100 in accordance with a first embodiment is shown. The LED 100 is capable of emitting visible light with a first color temperature, and includes a substrate 10, an LED chip 20 thermally attached to the substrate 10, an encapsulation 30 encapsulating the LED chip 20, and a phosphor layer 40 containing phosphor particles and disposed on an outer surface of the encapsulation 30.

The substrate 10 can be made of metallic material, such as copper, copper-alloy, aluminum or aluminum-alloy. The substrate 10 can also be made of a ceramic material with properties of electrically insulating and high thermal conductivity, such as Al₂O₃, AIN, SiC or BeO₂. A groove 12 with a trapeziform cross section is defined in a top face of the substrate 10. The LED chip 20 is received in the groove 12 and attached to an inner face of the groove 12. The encapsulation 30 is filled in the groove 12, and the outer surface of the encapsulation 30 is coplanar with the top face of the substrate 10 adjacent to the groove 12.

The encapsulation 30 can be made of transparent material, such as silicone, epoxy resin, PC (polycarbonate) or PMMA (polymethyl methacrylate).

The phosphor layer 40 can be sulfides, aluminates, oxides, silicates, nitrides or oxinitrides. Particularly, the phosphor layer 40 can be of Ca₂Al ₁₂O₁₉:Mn, (Ca,Sr,Ba)Al₂O₄:Eu, Y₃Al₅O₁₂:Ce³⁺(YAG), Tb₃Al₅O₁₂:Ce³⁺ (TAG), BaMgAl₁₀O₁₇:Eu²⁺(Mn²⁺), Ca₂Si₅N₈:Eu²⁺, (Ca,Sr,Ba)S:Eu²⁺, (Mg,Ca,Sr,Ba)₂SiO₄:Eu²⁺, (Mg,Ca,Sr,Ba)₃Si₂O₇:Eu²⁺, Ca₈Mg(SiO₄)₄Cl₂ :Eu²⁺, Y₂O₂S:Eu³⁺, (Sr,Ca,Ba)Si_{X}O_{y}N_{Z}:Eu²⁺, (Ca,Mg,Y)Si_{w}AlₓO_{y}N_{z}:Eu²⁺, CdS, CdTe or CdSe. The phosphor layer 40 has a flat, rectangular cross section. The thickness T of the phosphor layer 40 is preferably 700µm or lower, and more preferably 500µm or lower. The phosphor layer 40 can be formed on the outer surface of the encapsulation 30 by a method such as spray coating or screen printing.

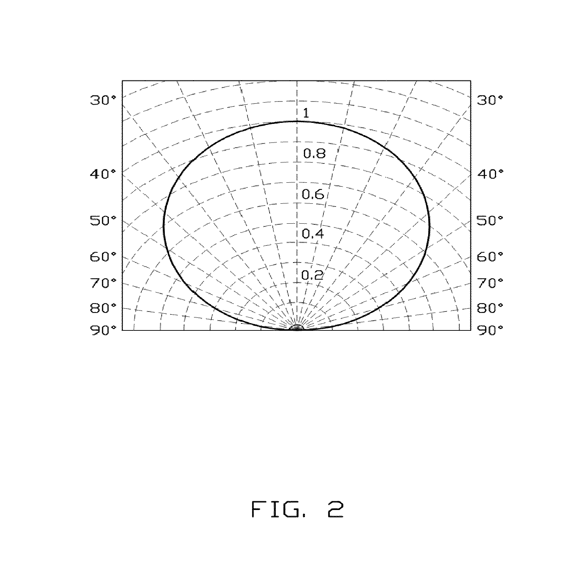

The LED chip 20 employs a semiconductor material capable of emitting visible light with a second color temperature. Referring to FIG. 2, a diagram illustrating a luminous intensity I distribution of the LED chip 20 is shown. The luminous intensity I of light generated by the LED chip 20 and a radiation angle θ are in Lambertian distribution and satisfy following formula: I = l₀xcosθ, wherein the radiation angle θ is not lower than 0°, and is not higher than 90°, and l₀ represents a luminous intensity at a central axis O of the LED chip 20, and the radiation angle θ is an angle between the light generated by the LED chip 20 and the central axis O.

The concentration C of the phosphor particles in the phosphor layer 40 and the radiation angle θ satisfy following formula: C = C₀xcos^{θ}, wherein the radiation angle θ is not lower than 0°, and is not higher than 90°, and C ₀ is a concentration of the phosphor particles in the phosphor layer 40 at the central axis O of the LED chip 20, and the radiation angle θ is the angle between light and the central axis O. Namely, the concentration C of the phosphor particles in the phosphor layer 40 and the radiation angle θ are also in Lambertian distribution.

Since the concentration C of the phosphor particles in the phosphor layer 40 and the luminous intensity I of light generated by the LED chip 20 relative to the radiation angle θ are in Lambertian distribution, the smaller is the radiation angle θ, the greater are the luminous intensity I and the concentration C. Therefore, a greater proportion of light with the second color temperature emitted from the LED chip 20 would be absorbed and converted into light with a third color temperature by the phosphor layer 40, and then light with the second color temperature which is scattered by the phosphor layer 40 and the light with the third color temperature combine and finally produce light with the first color temperature. Thus, when the concentration C of the phosphor particles in the phosphor layer 40 and the luminous intensity I of light generated by the LED chip 20 are in Lambertian distribution, the first color temperature of light emitted from the entire LED 100 is likely to be uniformly distributed within the range of the radiation angle θ.

In the above, the concentration C of the phosphor particles in the phosphor layer 40 is variable relative to the luminous intensity I of light generated by the LED chip 20 so as to achieve a uniform light distribution of the entire LED 100 with the first color temperature. However, it is understandable that when the particle number N of the phosphor particles in the phosphor layer 40 or the thickness T of the phosphor layer 40 relative to the luminous intensity I of light generated by the LED chip 20 are in Lambertian distribution, a uniform distribution of the first color temperature of light emitted from the entire LED 100 can also be achieved. That is to say, the particle number N of the phosphor particles in the phosphor layer 40 and the radiation angle θ satisfy following formula: N = N₀xcosθ, wherein the radiation angle θ is not lower than 0°, and is not higher than 90°, and No is the particle number of the phosphor particles in the phosphor layer 40 at the central axis O of the LED chip 20, and the radiation angle θ is an angle between light and the central axis O; or the thickness T of the phosphor layer 40 and the radiation angle θ satisfy following formula: T = T₀xcosθ, wherein the radiation angle θ is not lower than 0°, and is not higher than 90°, and T₀ is the thickness of the phosphor layer 40 at the central axis O of the LED chip 20, and the radiation angle θ is an angle between light and the central axis O. The smaller is the radiation angle θ, the greater are the luminous intensity I and the particle number N or the thickness T. Accordingly, a greater proportion of light with the second color temperature emitted from the LED chip 20 would be absorbed and converted into light with a third color temperature by the phosphor layer 40, and then light with the second color temperature which is scattered by the phosphor layer 40 and the light with the third color temperature combine and finally produce light with the first color temperature. Thus, when the particle number N of the phosphor particles in the phosphor layer 40 or the thickness T of the phosphor layer 40 relative to the luminous intensity I of light generated by the LED chip 20 are in Lambertian distribution, the first color temperature of light emitted from the entire LED 100 is likely to be uniformly distributed within the range of the radiation angle θ.

When the concentration C of the phosphor particles in the phosphor layer 40 is in Lambertian distribution relative to the radiation angle θ, the thickness T of the phosphor layer 40 can be uniform. When the particle number N of the phosphor particles in the phosphor layer 40 is in Lambertian distribution relative to the radiation angle θ, the thickness T of the phosphor layer 40 can be uniform. When the thickness T of the phosphor layer 40 is in Lambertian distribution relative to the radiation angle θ, the concentration C of the phosphor particles in the phosphor layer 40 can be uniform. When the thickness T of the phosphor layer 40 is in Lambertian distribution relative to the radiation angle θ, the particle number N of the phosphor particles in the phosphor layer 40 can be uniform.

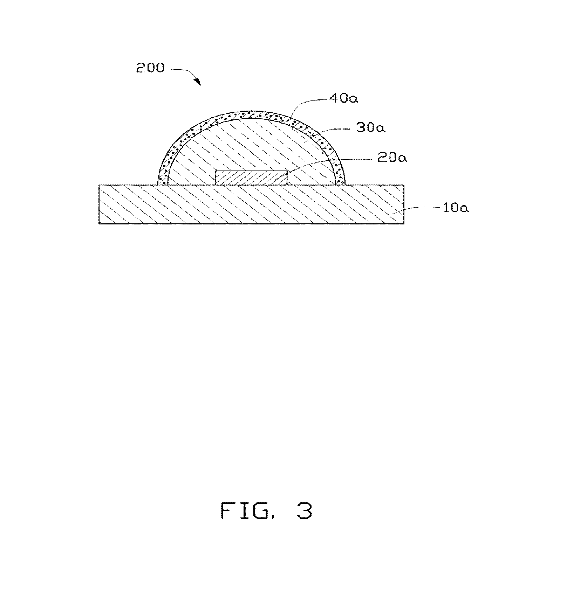

Also referring to FIG. 3, an LED 200 in accordance with a second embodiment is shown. The LED 200 includes a substrate 10a, an LED chip 20a thermally attached to the substrate 10a, an encapsulation 30a encapsulating the LED chip 20a, and a phosphor layer 40a disposed on an outer surface of the encapsulation 30a. The differences of the LED 200 relative to the LED 100 in the first embodiment are that: the substrate 10a of the LED 200 does not define any groove for receiving the LED chip 20a, the encapsulation 30a is hemispherical, and the phosphor layer 40a is curved and covered on the hemispherical outer surface of the encapsulation 30a.

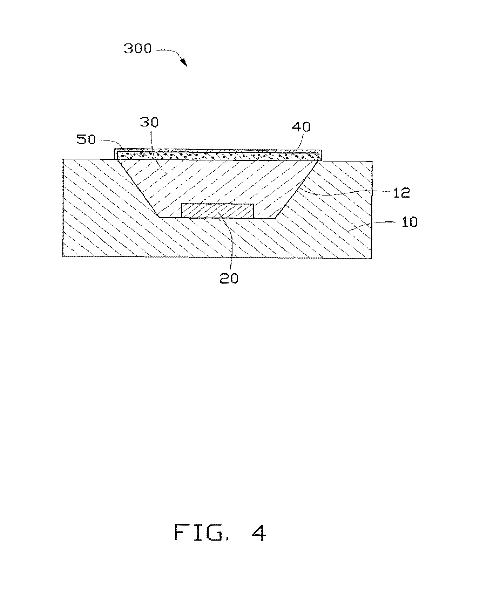

Also referring to FIG. 4, an LED 300 in accordance with a third embodiment is shown. The differences of the LED 300 relative to the LED 100 in the first embodiment are that: a transparent protective layer 50 is covered on an outer surface of the phosphor layer 40, and the protective layer 50 is made of the same material as the encapsulation 30.

It is to be understood, however, that even though numerous characteristics and advantages of certain embodiments have been set forth in the foregoing description, together with details of the structures and functions of the embodiments, the disclosure is illustrative only, and changes may be made in detail, especially in matters of shape, size, and arrangement of parts within the principles of the disclosure to the full extent indicated by the broad general meaning of the terms in which the appended claims are expressed.

## Claims

1. An LED comprising:
an LED chip for generating light;
an encapsulation encapsulating the LED chip; and
a phosphor layer disposed on an outer surface of the encapsulation, the phosphor layer containing phosphor particles therein;
wherein a luminous intensity I of light generated by the LED chip is in Lambertian distribution to a radiation angle θ, and the luminous intensity I at the radiation angle θ satisfies following formula: I = l₀xcosθ, here the radiation angle θ is not lower than 0°, and is not higher than 90°, and l₀ is a luminous intensity at a central axis of the LED chip, and the radiation angle θ is an angle between the light and the central axis; and
wherein one of parameters of concentration, particle number of the phosphor particles in the phosphor layer and a thickness of the phosphor layer is also in Lambertian distribution relative to the radiation angle θ.

2. The LED of claim 1, wherein the concentration of the phosphor particles in the phosphor layer is in Lambertian distribution relative to the radiation angle θ, and the thickness of the phosphor layer is uniform.

3. The LED of claim 1, wherein the particle number of the phosphor particles in the phosphor layer is in Lambertian distribution relative to the radiation angle θ, and the thickness of the phosphor layer is uniform.

4. The LED of claim 1, wherein the thickness of the phosphor layer is in Lambertian distribution relative to the radiation angle θ, and the concentration of the phosphor particles in the phosphor layer is uniform.

5. The LED of claim 1, wherein the thickness of the phosphor layer is in Lambertian distribution relative to the radiation angle θ, and the particle number of the phosphor particles in the phosphor layer is uniform.

6. The LED of claim 1, wherein a transparent protective layer is covered on an outer surface of the phosphor layer.

7. The LED of claim 1, wherein the thickness of the phosphor layer is 700µm or lower.

8. The LED of claim 7, wherein the thickness of the phosphor layer is 500µm or lower.

9. The LED of claim 1, further comprising a substrate, the LED chip being fixed on the substrate.

10. The LED of claim 9, wherein a groove concaves from a face of the substrate, the LED chip is received in the groove and attached to a bottom of the groove, and the encapsulation is filled in the groove of the substrate.

11. The LED of claim 10, wherein the outer surface of the encapsulation is coplanar with the face of the substrate defining the groove, and the phosphor layer is flat.

12. The LED of claim 9, wherein the substrate is made one of copper, copper-alloy, aluminum and aluminum-alloy.

13. The LED of claim 9, wherein the substrate is made of a ceramic material with properties of electrically insulating and thermal conductivity.

14. The LED of claim 13, wherein the substrate is made of one of Al₂O₃, AIN, SiC and BeO₂.

15. The LED of claim 1, wherein the encapsulation is hemispherical, and the phosphor layer is curved and covered on the hemispherical outer surface of the encapsulation.
